# EUROPEAN PATENT APPLICATION

(11) **EP 1 073 285 A1**
(43) Date of publication of application: **31.01.2001**
(21) Application number: 99203561.8
(22) Date of filing: 28.10.1999
(51) Int. Cl.: H04Q 1/02, H04Q 1/10, H05K 5/00, H05K 7/18, H02B 1/30

(54) **Unit housing cell equipment for cellular telephones**

(71) Applicant: N.V. Belgacom Mobile S.A., 1210 Brussels (BE)
(72) Inventor: Vinkx, Philip, N.V.BELGACOM MOBILE S.A., 1210 Brussels (BE); Bauweraerts, Koen, N.V.BELGACOM MOBILE S.A., 1210 Brussels (BE)
(74) Representative: Van Straaten, Joop

(57) **Abstract**

A unit housing cell equipment is constituted by a number of metal cabinets, placed and joined to form substantially a cage of Faraday. One of the units comprise radio equipment and preferably only the radio equipment, another one houses the supporting equipment (including supply equipment such as for instance batteries).

## Description

The invention relates to a unit housing cell equipment for cellular telephones including radio equipment and supporting equipment.

Such units are known and used wide-spread in cellular telephones systems.

An example of such a unit is given in United States patent US 5,911,117. In US 5,911,117 a unit is described which is a fixed structure. The structure, a so-called services protection structure (SPE), houses radio equipment (BTS) as well as supporting equipment inside the structure. The structure itself is a large cabinet on a concrete pad within which there are compartments provided for housing various types of equipment.

Although this known unit has advantageous properties, more in particular installation of various equipment can be better planned, there are mayor disadvantages. The structure takes up space and once placed cannot be moved.

US 5,991,117 discloses a unit designed for outdoor use. For indoor use commonly a room is used which is sheltered from disturbing electromagnetic radiation, and in which room equipment such as BTS and supporting equipment is placed.

Such 'indoor units' are expensive and require a relatively large room to be used for the unit.

As more and more cellular telephones are used, the need for units housing cell equipment for cellular telephones increases. At the same time as the need for such units increases there is a trend to impose ever more restrictions on the available place for such a unit, for instance building permits being refused for building such units at sites where the view may be obstructed and ever more emphasis is placed on flexibility, i.e. the freedom to place such units at a desired position and, if needed to remove them again.

Using the above described known units it is difficult if possible at all to meet these conflicting demands.

It is an object of the invention to provide for a unit housing cell equipment for cellular which is better capable of meeting the above demands.

To this end the unit is characterised in that the unit comprises two or more separately movable cabinets the outer sides of which are substantially made of metal material, a first of said cabinets housing the radio equipment, a second of said cabinets housing the supporting equipment, each cabinet having means to join a side to a corresponding side of an adjoining cabinet and each of the cabinets having means for cables going from said cabinet to the adjoining cabinet through said joining sides, the assembly of the cabinets substantially forming the unit.

With 'outer sides' are meant the sides (including top and bottom) that do not get joined when the two cabinets are joined. Preferably however, also these joining sides are also substantially made of metal material. 'Substantially made of metal material' includes metal sides which may be provided with coatings of non-metal nature (protective coatings of some sort), paint and other material. Metal includes metal alloys and metal compositions (steel, aluminium alloys etc.). The sides substantially made of metallic material may also comprise metallic material in or on a plastic material substrate.

Compared to the known indoor units the invention offers the great advantage that it is not needed to use (sacrifice) a room for the unit. The unit substantially forms a cage of Faraday (due to the metal outer sides of the cabinets) substantially sheltering the equipment inside the unit from stray electromagnetic interference. It is thus not needed to shelter a complete room. Another advantage is that the cabinets can be moved separately to the place where the unit is to be located. Thus the cabinets may be for instance moved to a cellar or attic, although the unit as a whole would never pass the stairs leading up to (down to) said attic or cellar. Thus the unit can be installed in spaces (public and private) which before could not be used for housing cell equipment. Preferably the cabinet housing the radio equipment houses the radio equipment but not the supporting equipment and/or electrical supply equipment such as batteries. The supporting equipment and electrical supply equipment is housed in the cabinet for the supporting equipment. Such a dissection of functions over the cabinets gives the important advantage over embodiments in which the cabinet housing radio equipment houses also part of the supporting equipment that the radio and supporting equipment can be services and swapped, if needed, independently. These embodiments are in particular of importance if the unit comprise more than one cabinet of one kind combined with one or more cabinets of the other kind. Both types of cabinets form autonomous entities. Preferably the radio equipment is placed on a slide, which can be slit in and out of the cabinet housing the radio equipment. This reduces strongly the time needed during replacement of or servicing or repair of the radio equipment. Preferably the cabinets comprise wall elements and a frame which are detachable from and attachable to each other by means of reversible attachment means. In these preferred embodiments the cabinets can be taken apart and (re)assembled at the desired place. This further increases the possible places in which the unit can be used. Preferably the frame also comprises frame elements which can be detached from and attached to each other. Another advantage of the unit in accordance with the invention over known indoor 'units' is the fact that the interference with stray signals is reduced. In the known indoor 'units' the radio equipment and the supporting equipment are linked with cables which, although sheltered from interference from outside, are not so well sheltered from stray sources inside the room. Furthermore it is very difficult to fully shelter a room. Leaks (for instance windows or doors) occur. A room with many windows is very difficult to shelter. In the unit in accordance with the invention the equipment is placed in a closed cage of Faraday, formed by the unit enabling the unit to be positioned for instance in a room with many windows or some public hall way, without fear of interference. As stated before preferably also the joining sides of the two cabinets are made of metal. This results in at least some cross-interference between the radio and supporting equipment being eliminated.

Preferably the two cabinets are provided with means for lifting the cabinets, either from the top (for instance hooks or eyes) or from the bottom (for instance holes to stick the teeth of a lift truck in).

Preferably at least one of the cabinets has means for joining a further cabinet to the unit. Cabinets can be added at either side (left and right) of such a least one of the cabinet.

This enables for instance to build a unit comprising one cabinet housing controlling equipment joined with two or more cabinets housing radio equipment. This modular approach (i.e. a unit can comprise a number of joined cabinets) has a number of advantages. It restricts the needed space, yet without sacrificing flexibility. Replacement or service of equipment be it radio equipment or supporting equipment can be done with very little time loss. To a unit which comprises a cabinet having supporting equipment and an adjoining cabinet having radio equipment to be replaced or serviced, an additional cabinet having radio equipment is adjoined for instance to a 'free' side of the cabinet having supporting equipment. The radio equipment of said additional cabinet is checked or calibrated or prepared to be connected. When all preparations are made, the cables connecting the supporting equipment to the radio equipment in the first cabinet with radio equipment are detached, and connected to the radio equipment in the additional cabinet. This takes very little time. The first cabinet with radio equipment can now be detached (separated) from the unit and removed, repaired or serviced without any problems and without stopping the transmission of the unit.

These and other objects of the invention will be apparent from and elucidated with reference to the embodiments described hereinafter.

Figs. 1A to 1C show a unit in accordance with the invention for indoor use.

Fig. 2a to 2D show a unit in accordance with the invention for indoor use comprising two cabinets with radio equipment.

Figs. 3 to 5 show a unit in accordance with the invention for outdoor use.

The Figures are not drawn to scale. In the Figures, like reference numerals generally refer to like parts.

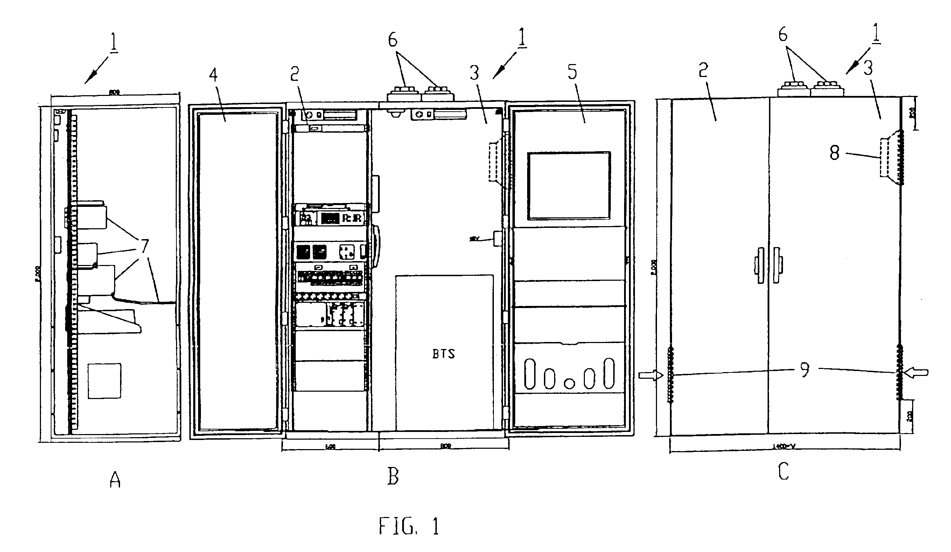

Fig. 1A shows a open side view of a unit in accordance with the invention, Fig. 1B a frontal view with opened doors and Fig. 1C a frontal view with closed doors.

The unit 1 comprises two cabinets 2 and 3. The cabinets form each separately movable cabinets. Said cabinets can be moved as independent modules and the unit can be assembled at the required location. In this example the left hand cabinet 2 houses supporting equipment 7 behind door 4. The right-hand cabinet houses radio equipment (BTS) behind door 5. Connections 6 for connection to antenna's are also provided. Such connection can be also provided in cabinet 2 on various sides. Cabinet 3 also comprise a fan 7 and grills 9 for fresh air and cooling. When the two cabinets are joined the doors are closed (fig. 1C). When the two cabinets are joined the unit is substantially formed. 'Substantially formed' does not exclude that some accessory details are added to the units after joining the unit together such as a fire extinguisher, a coat of paint, a brace to attach to a wall etc. As explained above the modular approach renders several advantages. This unit may indoor be used at places where before such units could not be used, for instance in rooms which due to for instance the presence of windows or large disturbing electro-magnetic fields could not be used. It can even be used in places which do not provide access to a unit having the size of the unit shown in figs. 1A to 1C. All that is required is an access large enough to pass the largest of the two cabinets (in this example the right hand cabinet) in case the cabinets are assembled/manufactured outside the place. Especially in those circumstances where the unit comprises more than two cabinets, this is a distinct advantage. In case the cabinets (or at least the larger of the cabinets) comprises wall and frame elements which can be taken apart and reassembled at will by reversible attachment means, the flexibility of the unit is even greater, because the access only has to be large enough to enable the largest of said elements to pass. If one of the cabinets needs to be replaced and/or the equipment needs to be serviced, such can be easily done without unduly interrupting the transmission, as explained above.

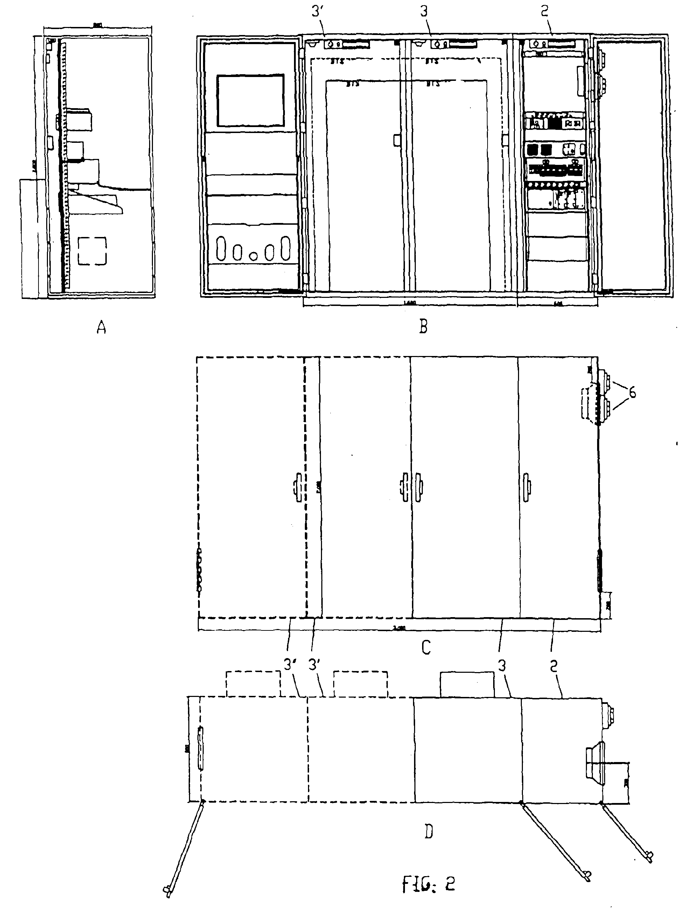

Figs. 2a to 2D show in respectively open side view, front view with open doors, front view with closed doors and top view, in more detail a further embodiment of the unit in accordance with the invention. In this embodiment next to cabinet 3 a further cabinet 3' is integrated into the unit. This unit also houses radio equipment.

Figs. 1A to 2D show a unit primarily used for/designed for indoor use.

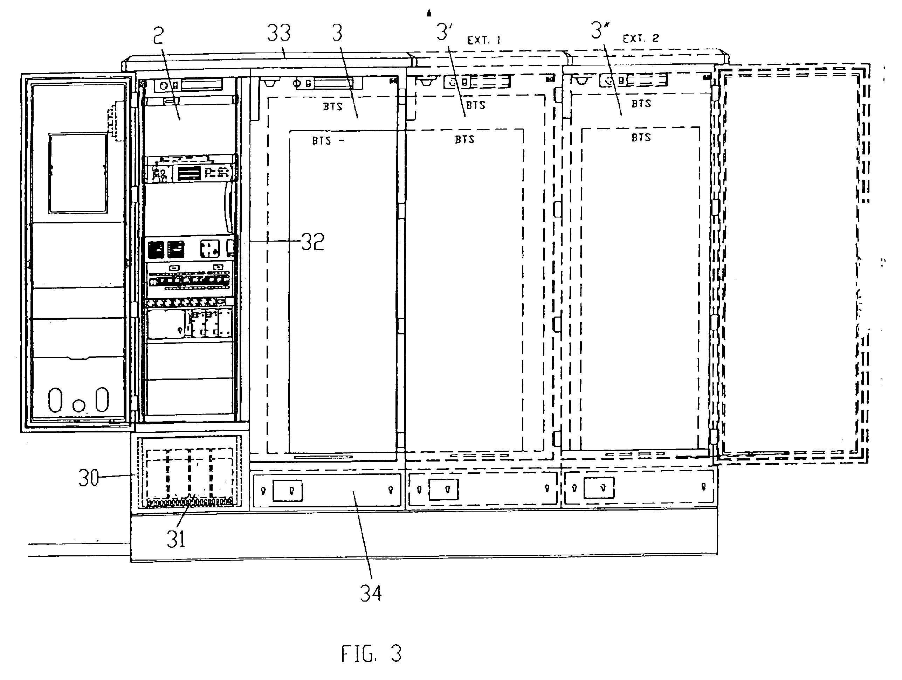

Figs. 3 to 5 show a unit in accordance with the invention primarily used for/designed for outdoor use. The same advantages (flexibility and ease of service, repair) hold for these design as for the above design.

As far as outdoor units are concerned it may seem at first instance that the requirement of space is less of a problem then indoor since there seem to be more room. However the most need for such units is in heavily populated areas which usually mean heavily built-up area. Often the units are placed on roof tops or similar surfaces. Accessibility of such places leaves much to be desired. Because of the modular approach of the invention, i.e. the unit substantially being built up of relatively small cabinets, places which could not be used for units or which required an outdoor housing for radio equipment and an indoor housing for the supporting equipment can now be used.

Fig. 3 show a open frontal view of an outdoor unit. The outdoor unit comprises a separate compartment in which batteries 31 are provided in a sliding tray. The tray prevents battery fluid, if a leak occurs, from entering cabinet 2. The cabinets 2 and 3 are in this embodiment, which is especially of advantage for outdoor units separated from each other by a metal separating wall 32. Through said wall signal or cable throughputs are provided. Such metal walls reduces cross-talk between the two cabinets. To further reduce cross-talk filters may be provided in the signal or cable throughputs. The unit is capped by a metal upper part 33, made of one piece. Such part is preferably custom made for each configuration of cabinets. The metal cap in one piece not only provide further shelter from stray electro-magnetic fields but also provided protection for the cabinets from rain an other weather condition. Having a limited number of standard caps enables an extension 3', 3'' to be placed very quickly.

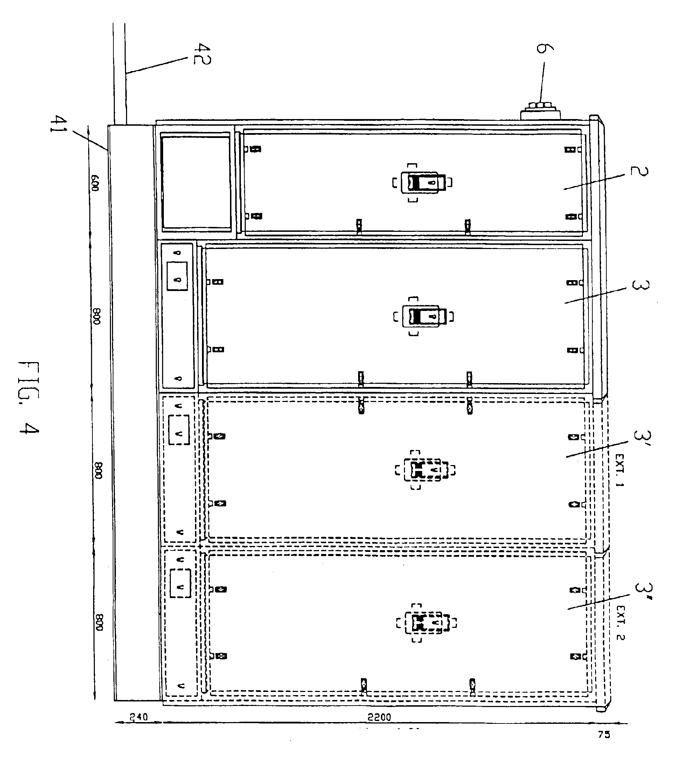

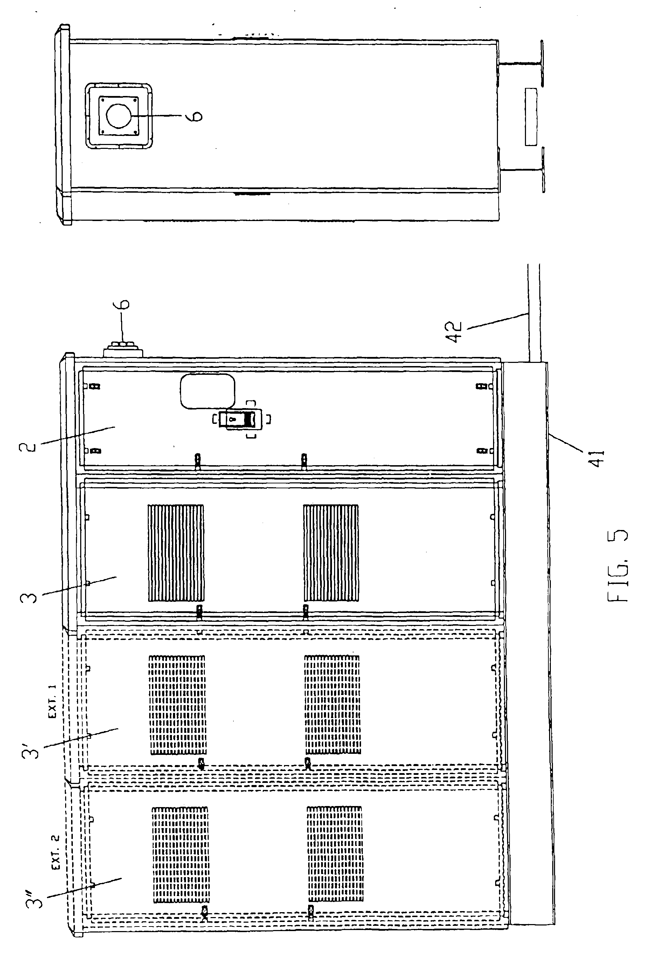

Cabinets 3 preferably have a storage part 3 which is slidable and in which preferably a canvas is stored. Such canvas can be used to protect the unit from rain when the doors have to be opened. Figure 4 shows a frontal view with closed doors. Preferably the unit is placed on a hollow beam, for instance a I-beam 41. Through said I-beam cables and supply lines 42 may be led to the unit. Finally Fig. 5 gives a back view and a side view of an outdoor unit.

For both indoor and outdoor units it holds that should the need arise to remove the unit this can easily be done.

In short the
Invention can be described by:

A unit housing cell equipment is basically constituted by a number of metal cabinets, placed and joined to form substantially a cage of Faraday. One of the units comprise radio equipment and preferably only the radio equipment, another one houses the supporting equipment (including supply equipment such as for instance batteries).

It will be clear that within the concept of the invention many variations are possible.

## Claims

1. A unit housing cell equipment for cellular telephones including radio equipment and supporting equipment, characterised in that the unit comprises two or more separately movable cabinets the outer sides of which are substantially made of metal material, a first of said cabinets housing the radio equipment, a second of said cabinets housing the supporting equipment, each cabinet having means to join a side of said cabinet to a corresponding side of another of the cabinets and each of the cabinets having means for cables going from said cabinet to an adjoining cabinet through the joining sides, the assembly of the cabinets substantially forming the unit.

2. A unit as claimed in claim 1 or 2, characterised in that the joining sides are substantially made of metal material.

3. A unit as claimed in any of the preceding claims, characterised in that the cabinets comprise wall elements and a frame which are detachable from and attachable to each other by means of reversible attachment means.

4. A unit as claimed in any of the preceding claims, characterised in that the first of said cabinets houses the radio equipment but not supporting equipment or electrical supply equipment.

5. A unit as claimed in claim 4, characterised in that the radio equipment is placed on a slide.

6. A unit as claimed in any of the preceding claims, characterised in that it is placed indoor.

7. A unit as claimed in any of the preceding claims, characterised in that it is placed outdoor.

8. A unit as claimed in claim 7, characterised in that over the cabinets a metal cap is placed.

9. A unit as claimed in any of the preceding claims, characterised in that the cabinets are provided with means for lifting the cabinets.
